# EUROPEAN PATENT APPLICATION

(11) **EP 4 786 078 A1**
(43) Date of publication of application: **05.08.2026**
(21) Application number: 25218461.9
(22) Date of filing: 25.11.2025
(51) Int. Cl.: B22F 10/38, B22F 10/28, B22F 12/90, B33Y 50/00, B22F 10/80, G05B 13/02, B22F 10/85, B33Y 30/00, B33Y 10/00, G06N 3/08, G06N 20/00, G06N 20/10, G06F 30/20

(54) **MODELING AND DETERMINING LIFE EXPECTANCY OF PRODUCTS OBTAINED BY METAL ADDITIVE MANUFACTURING PROCESSES USING MICROSTRUCTURE AND SUPER IMPOSED DEFECTS**

(30) Priority: 25.11.2024 US 202418958910
(71) Applicant: RTX Corporation, Farmington, CT 06032 (US)
(72) Inventor: LYNCH, Matthew E., Canton (US); LIU, Jingfu, Eden Prairie (US); MONDAL, Sudeepta, Manchester (US); SARKAR, Soumalya, Glastonbury (US); NORMAN, Joshua M., South Windsor (US); FISHER, Brian A., West Hartford (US)
(74) Representative: Dehns

(57) **Abstract**

An additive manufacturing apparatus (100) includes a chamber (110), a controller (140) including processing circuitry and a memory (144), the controller (140) operable to determine an expected life of an additive manufactured part (130), by receiving an initial part design and initial additive manufacturing parameters and 1) utilizing a machine learning model trained on historic images to estimate grain structure based upon the initial part design and initial additive manufacturing parameters, 2) manufacturing a part (130) by additive manufacturing based upon the initial part design and initial additive manufacturing parameters, and monitoring for the location of likely defects during the manufacturing based upon sensed information during the manufacturing, 3) inferring potential defects' associated shapes, sizes, and morphologies, combining 2) and 3) to reach a defect map, superimposing the defect map on the grain structure and determining an expected life of the part (130) based upon the superimposed defect map and grain structure. A method is also disclosed.

## Description

### TECHNICAL FIELD

This application relates to a method and apparatus for predicting an expected life of an additively manufactured part utilizing predicted grain microstructure and defects.

### BACKGROUND

Additive manufacturing is becoming more and more prevalent in manufacturing metal parts. However, it is challenging to evaluate the expected life of an additively manufactured part. Additive manufacturing processes could be said to be stochastic. Current methods of predicting the expected life of an additively manufactured part typically take a long time. Further, they require high performance computing platforms.

In addition, the modeling tends to be limited to small representative volume elements, and does not apply to macro-level or complex shapes.

### SUMMARY

In a featured embodiment, an additive manufacturing apparatus includes a chamber, a controller including processing circuitry and a memory, the controller operable to determine an expected life of an additive manufactured part, by receiving an initial part design and initial additive manufacturing parameters and 1) utilizing a machine learning model trained on historic images to estimate grain structure based upon the initial part design and initial additive manufacturing parameters, 2) manufacturing a part by additive manufacturing based upon the initial part design and initial additive manufacturing parameters, and monitoring for the location of likely defects during the manufacturing based upon sensed information during the manufacturing, 3) inferring potential defects' associated shapes, sizes, and morphologies, combining 2) and 3) to reach a defect map, superimposing the defect map on the grain structure and determining an expected life of the part based upon the superimposed defect map and grain structure.

In another embodiment according to the previous embodiment, the controller is operable to compare the expected life to an acceptable life, and updates at least one of the initial part design and the initial additive manufacturing parameters should the expected life not be equal or above the acceptable life, and returning back to earlier three parallel steps to determine a new superimposed defect map and grain structure based upon the update.

In another embodiment according to any of the previous embodiments, if the expected life is greater than or equal to the acceptable life, then the controller is operable to cause to the part to be manufactured.

In another embodiment according to any of the previous embodiments, the defect shape includes generally smooth shapes as keyhole pores.

In another embodiment according to any of the previous embodiments, a lack of fusion pores are also identified as defects, which have jagged shapes.

In another embodiment according to any of the previous embodiments, a lack of fusion pores are also identified as defects, which have jagged shapes.

In another embodiment according to any of the previous embodiments, the 3) identification of a potential defects and associated shapes and location relies upon a process model that finds expected voids based upon phases, thermal history, or other physics-based insight in the additive manufacturing part.

In another embodiment according to any of the previous embodiments, among the additive manufacturing parameters are at least laser power and laser speed.

In another embodiment according to any of the previous embodiments, the controller is operable such that the identification of defects based upon on sensed information during the manufacturing steps is acted upon while manufacturing is still occurring to correct later resultant defects in subsequent layers.

In another embodiment according to any of the previous embodiments, the controller is operable such that the identified defects based upon the sensed information during the manufacturing steps is stored and utilized at a later point to evaluate the identification of location of likely defects.

In another featured embodiment, a method of determining an expected life of an additive manufactured part includes the steps of receiving an initial part design and initial additive manufacturing parameters and 1) utilizing a machine learning model trained on historic images to estimate grain structure based upon the initial part design and initial additive manufacturing parameters, 2) manufacturing a part by additive manufacturing based upon the initial part design and initial additive manufacturing parameters, and monitoring for the location of likely defects during the manufacturing based upon sensed information during the manufacturing, 3) inferring potential defects, associated shapes, sizes and morphologies, combining steps 2) and 3) to reach a defect map, superimposing the defect map on the grain structure and determining an expected life of the part based upon the superimposed defect map and grain structure.

In another embodiment according to any of the previous embodiments, the method compares the expected life to an acceptable life, and updates at least one of the initial part design and the initial additive manufacturing parameters should the expected life not be equal or above the acceptable life, and returning back to earlier three parallel steps to determine a new superimposed defect map and grain structure based upon the update.

In another embodiment according to any of the previous embodiments, if the expected life is greater than or equal to the acceptable life, then the part is manufactured.

In another embodiment according to any of the previous embodiments, the defect shape includes generally smooth shapes as keyhole pores.

In another embodiment according to any of the previous embodiments, a lack of fusion pores are also identified as defects, which have jagged shapes.

In another embodiment according to any of the previous embodiments, a lack of fusion pores are also identified as defects, which have jagged shapes.

In another embodiment according to any of the previous embodiments, the step 3) identification of a potential defects and associated shapes and location relies upon a process model that finds expected voids based upon phases in the additive manufacturing part.

In another embodiment according to any of the previous embodiments, among the additive manufacturing parameters are at least laser power and laser speed.

In another embodiment according to any of the previous embodiments, the step 2) identification of defects based upon on sensed information during the manufacturing steps is acted upon while manufacturing is still occurring to correct later resultant defects in subsequent layers.

In another embodiment according to any of the previous embodiments, the step 2) identified defects based upon the sensed information during the manufacturing steps is stored and utilized at a later point to evaluate the identification of location of likely defects.

The present disclosure may include any one or more of the individual features disclosed above and/or below alone or in any combination thereof.

These and other features of the present invention can be best understood from the following specification and drawings, the following of which is a brief description.

### BRIEF DESCRIPTION OF THE DRAWINGS

Figure 1 schematically shows an additive manufacturing apparatus.
Figure 2A shows an overview of a method and system for performing a lifing prediction according to this disclosure.
Figure 2B shows the shape of predicted defects.
Figure 2C shows a flaw superimposed over grain structure.
Figure 2D shows a distinct type flaw superimposed over grain structure.
Figure 3 is a flow chart of a method under this disclosure.

### DETAILED DESCRIPTION

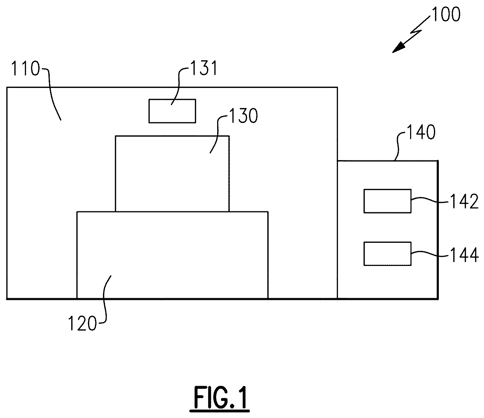

Figure 1 schematically illustrates an additive manufacturing machine 100, such as a laser powder bed fusion additive manufacturing machine. In alternate examples, the powder bed fusion machine can be an electron beam powder bed fusion machine. Other types of additive manufacturing machines may also be used. The exemplary additive manufacturing machine 100 includes a manufacturing chamber 110 with a platform 120 upon which a part 130 is additively manufactured. A controller 140 is connected to the chamber 110 and is operable to control an additive manufacturing system 131 according to any known additive manufacturing controls. As known, system 131 will deposit and then heat a fluent material in layers to form part 130.

Included within the controller 140 is one or more processors 142 that are collectively operable to receive and interpret input operations to define a sequence of the additive manufacturing, and memory 144 operable to store software instructions (e.g., modules) for directing the controller 140 and for analyzing received operations. As utilized herein "operations" refers to instructions specifying operational conditions and sequences for one or more step in an additive manufacturing process. The controller 140 can, in some examples, include user interface devices such as a keyboard and view screen. In alternative examples, the controller 140 can include a wireless or wired communication apparatus for communicating with a remote user input device such as a PC.

In an example operation, a part design is provided by a user to the controller 140. The part design is typically a 3D modeling file, such as an STL file. The controller 140 includes internal software modules operable to convert the STL file into an additive manufacturing process, and the additive manufacturing machine 100 executes the process to create the part.

Flaws such as keyhole or lack of fusion can occur either as a result of non-optimal machine parameters or randomly as a result of stochastic variation of uncontrolled and uncontrollable build parameters during additive manufacturing operation.

Included within the controller 140 is a module for determining when a process will generate systematic or preventable flaws, and optimize the performance parameters of the additive manufacturing system 100 accordingly. However, even when optimized, such additive manufacturing processes may still generate the stochastic flaws, and a manufacturing process that is certified as being free of preventable flaws may still include stochastic flaws and be unacceptable for a given application.

In order to determine if an operation is likely to generate stochastic flaws, the controller 140 includes an analysis tool that receives a part design and a set of additive manufacturing parameters and determines the chance that the operation will generate flaws, and how many flaws are likely to develop.

The controller 140 may include one or more computer processors, memory, storage means, network devices, input and/or output devices, and/or interfaces. The computing devices may be collectively operable to execute one or more software programs. The computing devices may be operable to communicate with one or more networks established by one or more computing devices. The memory may include UVPROM, EEPROM, FLASH, RAM, ROM, DVD, CD, a hard drive, or other computer readable medium which may store data and/or the functionality of this description. The computing devices may be collectively operable to execute any of the functionality disclosed herein. The computing devices may be a desktop computer, laptop computer, smart phone, tablet, or any other computer device. Input devices may include a keyboard, mouse, touchscreen, etc. The output devices may include a monitor, speakers, printers, etc. Each of the computing devices may include one or more processors coupled to memory. The computing devices may be coupled to each other by one or more connections. The connection may be a wired and/or wireless connection. The connections may be established over one or more networks and/or other computing systems.

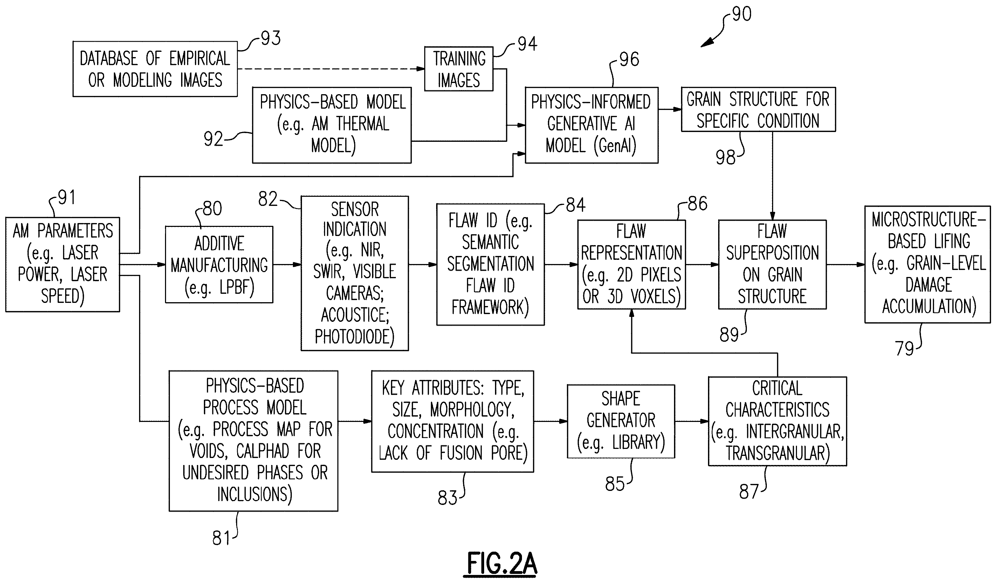

Figure 2A shows an overview 90 of a system and method for determining an expected life of an additively manufactured part. Controller 140 is operable to perform the methods disclosed herein. At 91 additive manufacturing parameters are initially determined. As an example, a laser power and laser speed may be determined. A physics-based model 92 such as an additive manufacturing thermal model is utilized along with training images 94 from a database 93. A physics informed generative AI model 96 then determines a grain structure 98 based upon the received additive manufacturing parameters and part design. At 80, an additive manufacturing system, such as system 100, manufactures the part 130 based upon the initial additive manufacturing parameters and part design.

At step 82, as the layers of material are being deposited to form the part, sensors sense the part's structure. As examples, near infrared information, short wave infrared information, visible camera information, acoustic or photo diode sensors may be utilized. This will then determine the likely location of a potential flaw at step 84.

The steps 82 and 84 can be done in real time as a part is being manufactured, which allows correction during the manufacturing process. On the other hand, the flaws could be determined afterward.

In parallel the parameters 91 are supplied to a second physics-based process model 81 for determining the likely location of phases in the part. In one example, a commercial tool known as CALPHAD, or calculation of phase diagrams, may be utilized. This then provides a map of locations which are in each of at least two phases. This information will help infer (e.g., identify) the type of flaws and predict whether a particular location is likely flaw free or likely includes flaws.

The inference of whether there may be a fusion or keyhole flaw is made based upon known flaw detection software. **In** particular, prior U.S. Patents 10,254,730; 10,252,512; 10,252,508; 10,252,509; 10,252,510; and 10,252,511 disclose such systems. One or more of the methods and apparatus disclosed in these patents may be utilized with this disclosure. The inference will change based upon the material being deposited (e.g., in layers) and may also be dependent upon laser parameter(s) or combinations.

The model 81 takes into account the impact of flaws in prior layers on later layers.

At step 83 key attributes of the identified flaws or defects 84, including the type, size, morphology, concentration, etc. may be inferred. At step 85, a shape is generated for the likely flaw. At step 87 critical characteristics of the flaw are identified. As an example, whether the flaws are intergranular or trans granular may be determined. This then feeds into a flaw representation 86 from step 84 to reach a flaw map.

The flaw representation 86 essentially draws a picture of the flaw at an expected location.

At step 89 the flaw map is superimposed on the grain structure from step 98. At step 91, a microstructure based lifing determination can be made utilizing a system such as a known part lifing prediction software. As one example, Sentient Sciences Component Lifing Prediction software may be utilized. This relies upon grain structure as an input and assesses likely damage accumulation and cracked nucleation on the microstructure.

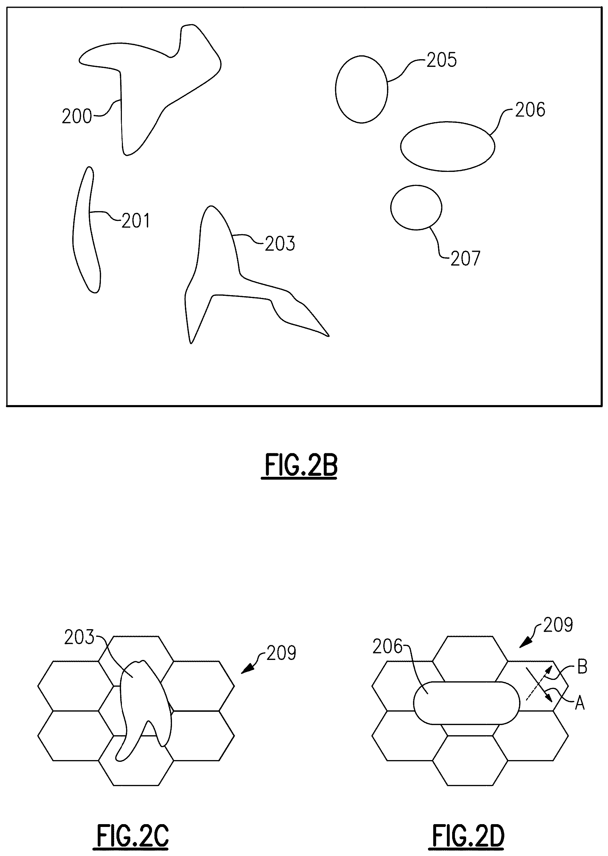

The flaw map in addition to the grain structure improves the determination by looking to how the grains are oriented. In addition, the stress concentration around a flaw will be considered. The stress is higher in irregular flaw areas. As an example, in Figure 2, a lack of fusion flaw 203 has sharp corners. The stress concentrations are particularly high around such sharp corners.

If the estimated life is not as seen as acceptable, the method may return to step 91, and change parameters or part design, and repeat the process.

As shown at Figure 2B, the shape generator 85 generates distinct shapes for lack of fusion pores 200, 201 and 203. These tend to be more jagged. In addition, keyhole pore shapes 205, 206 and 207 may be predicted.

The orientation of the flaws tend to be parallel to the layer itself, however, the orientation can be determined based upon the above-referenced flaw detection methods and apparatus.

Figure 2C shows a lack of fusion flaw 203 superimposed over grain structure 209.

While the grain 209 is shown approximately the same size as the flaws 203/206, in practice this is not case. In practice the grains could tend to be much smaller or larger than flaw sizes, however, they are illustrated in approximately equivalent size here to illustrate the orientation.

Figure 2D shows a keyhole pore flaw 206 superimposed over grain structure 211.

As can be appreciated, the grain structure illustrated in Figures 2C and 2D is quite simplified compared to actual determined grain structure.

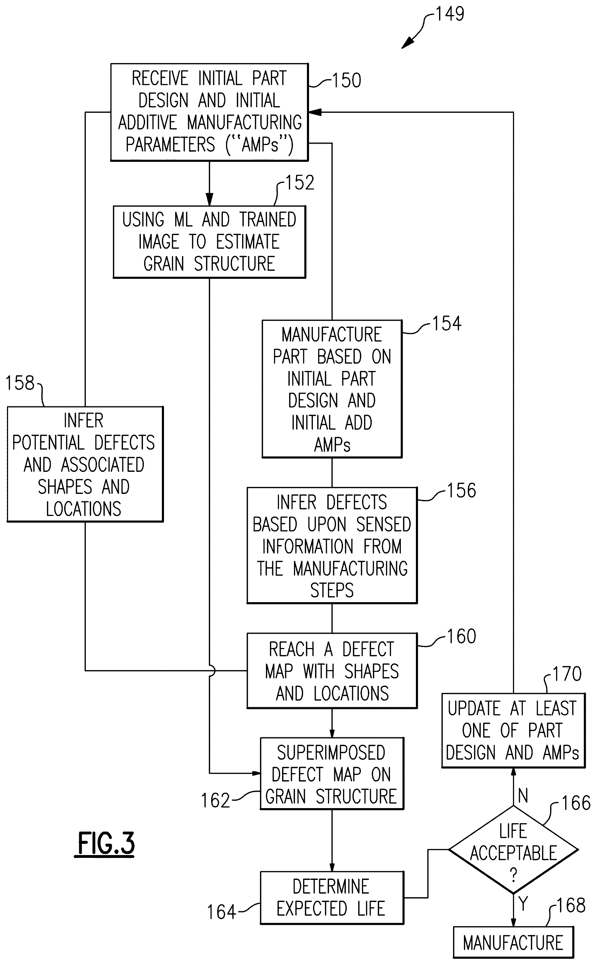

Figure 3 is a flow chart 149 for a method according to this disclosure. At step 150 a controller receives initial part design and initial additive manufacturing parameters. At step 152, artificial intelligence or machine learning is trained with historic images and is utilized to estimate grain structure.

At step 154 an additive manufactured part is made based upon the part design and (e.g., additive) manufacturing parameters. The manufacturing parameters may include one or more laser (e.g., fusion) parameters, such as beam intensity, material type, etc.

At step 156 the method identifies location of defects or flaws based upon one or more manufacturing (e.g., laser) parameters during manufacturing (e.g., laser parameters). Value(s) associated with the manufacturing parameter(s) may be obtained by one or more sensors.

In parallel, the chain 81/83/85/87 infers potential defects associated shapes and morphologies at step 158, which may be based on the manufacturing parameter(s) associated with step 156. At step 160, the method then reaches a defect map with shapes and locations.

At step 162 the defect map from step 160 is superimposed on the grain structure from step 152 using defect morphology and size inferred from step 158.

At step 164, an expected life is then determined based upon the grain structure and superimposed flaw(s) at the respective location and orientation.

At step 166 the method asks if the expected life is acceptable. If it is, then at step 168 a final part design may be manufactured. On the other hand, if the expected life is not acceptable then, at step 170, the method updates at least one of part design and the additive manufacturing parameters, and returns to step 150. One or more iterations of any of the steps of the method 149 may be performed, including steps 162 and/or 164, by varying grain orientation and/or grain size and morphology and/or flaw orientation and/or evaluating a different flaw geometry at the location determined by step 160.

Among the method updates could be reorientating the flaws, using a different flaw morphology, or changing the grain orientation and/or grain size and morphology. Returning to Figure 2D, an original grain orientation A is shown on a grain. If this results in an undesirable life span, the grain orientation and/or grain size and morphology could be changed such as shown in hatched line at B. Of course, in practice, such a change would likely not be as dramatic as illustrated.

Although embodiments have been disclosed, a worker of ordinary skill in this art would recognize that modifications would come within the scope of this disclosure. For that reason, the following claims should be studied to determine the true scope and content of this disclosure.

## Claims

1. An additive manufacturing apparatus comprising:
a chamber;
a controller including processing circuitry and a memory;
the controller operable to determine an expected life of an additive manufactured part, by:
receiving an initial part design and initial additive manufacturing parameters; and
1) utilizing a machine learning model trained on historic images to estimate grain structure based upon the initial part design and initial additive manufacturing parameters;
2) manufacturing a part by additive manufacturing based upon the initial part design and initial additive manufacturing parameters, and monitoring for the location of likely defects during the manufacturing based upon sensed information during the manufacturing;
3) inferring potential defects' associated shapes, sizes, and morphologies;
combining 2) and 3) to reach a defect map;
superimposing the defect map on the grain structure; and
determining an expected life of the part based upon the superimposed defect map and grain structure.

2. The apparatus as set forth in claim 1, wherein the controller is operable to compare the expected life to an acceptable life, and updates at least one of the initial part design and the initial additive manufacturing parameters should the expected life not be equal or above the acceptable life, and returning back to earlier three parallel steps to determine a new superimposed defect map and grain structure based upon the update, optionally wherein if the expected life is greater than or equal to the acceptable life, then the controller is operable to cause to the part to be manufactured.

3. The apparatus as set forth in claim 1 or 2, wherein the defect shape includes generally smooth shapes as keyhole pores.

4. The apparatus as set forth in any preceding claim, wherein a lack of fusion pores are also identified as defects, which have jagged shapes.

5. The apparatus as set forth in any preceding claim, wherein the 3) identification of potential defects and associated shapes and location relies upon a process model that finds expected voids based upon phases, thermal history, or other physics-based insight in the additive manufacturing part.

6. The apparatus as set forth in any preceding claim, wherein among the additive manufacturing parameters are at least laser power and laser speed.

7. The apparatus as set forth in any preceding claim, wherein the controller is operable such that the identification of defects based upon on sensed information during the manufacturing steps is acted upon while manufacturing is still occurring to correct later resultant defects in subsequent layers.

8. The apparatus as set forth in any preceding claim, wherein the controller is operable such that the identified defects based upon the sensed information during the manufacturing steps is stored and utilized at a later point to evaluate the identification of location of likely defects.

9. A method of determining an expected life of an additive manufactured part comprising the steps of:
receiving an initial part design and initial additive manufacturing parameters; and
1) utilizing a machine learning model trained on historic images to estimate grain structure based upon the initial part design and initial additive manufacturing parameters;
2) manufacturing a part by additive manufacturing based upon the initial part design and initial additive manufacturing parameters, and monitoring for the location of likely defects during the manufacturing based upon sensed information during the manufacturing;
3) inferring potential defects, associated shapes, sizes and morphologies;
combining steps 2) and 3) to reach a defect map;
superimposing the defect map on the grain structure; and
determining an expected life of the part based upon the superimposed defect map and grain structure.

10. The method as set forth in claim 9, wherein the method compares the expected life to an acceptable life, and updates at least one of the initial part design and the initial additive manufacturing parameters should the expected life not be equal or above the acceptable life, and returning back to earlier three parallel steps to determine a new superimposed defect map and grain structure based upon the update, optionally wherein if the expected life is greater than or equal to the acceptable life, then the part is manufactured.

11. The method as set forth in claim 9 or 10, wherein the defect shape includes generally smooth shapes as keyhole pores.

12. The method as set forth in any of claims 9-11, wherein a lack of fusion pores are also identified as defects, which have jagged shapes.

13. The method as set forth in any of claims 9-12, wherein the step 3) identification of potential defects and associated shapes and location relies upon a process model that finds expected voids based upon phases in the additive manufacturing part.

14. The method as set forth in any of claims 9-13, wherein among the additive manufacturing parameters are at least laser power and laser speed.

15. The method as set forth in any of claims 9-14, wherein the step 2) identification of defects based upon on sensed information during the manufacturing steps is acted upon while manufacturing is still occurring to correct later resultant defects in subsequent layers, optionally wherein the step 2) identified defects based upon the sensed information during the manufacturing steps is stored and utilized at a later point to evaluate the identification of location of likely defects.
